# EUROPEAN PATENT APPLICATION

(11) **EP 3 611 919 A1**
(43) Date of publication of application: **19.02.2020**
(21) Application number: 17929413.7
(22) Date of filing: 20.10.2017
(51) Int. Cl.: H04N 5/378, H04N 5/357

(54) **ANALOG READ CIRCUIT AND IMAGE SENSING MODULE**

(71) Applicant: Shenzhen Goodix Technology Co., Ltd., Shenzhen, Guangdong 518045 (CN)
(72) Inventor: TSENG, Chien-Jian, Shenzhen Guangdong 518045 (CN)
(74) Representative: Casalonga
(86) International application number: PCT/CN2017/107113
(87) International publication number: WO 2019/075749

(57) **Abstract**

The present invention provides an analog read circuit coupled to a pixel output end of a pixel circuit. The analog read circuit includes an amplifier and a sensing multiple sampling unit, wherein, in a selection interval, the sensing multiple sampling unit respectively implements a plurality of sensing sampling operations on pixel values at the pixel output end at a plurality of sensing sampling times to generate a plurality of sensing sampling results; and in an output interval, the sensing multiple sampling unit implements a sensing averaging operation on the plurality of sampling results. The amplifier outputs a read result that is related to a sensing average of the plurality of sensing sampling results.

## Description

### TECHNICAL FIELD

The present invention is related to an analog read circuit and an image sensing module; in particular, to an analog read circuit and an image sensing module capable of improving the signal-to-noise ratio as well as reducing the circuit area and power consumption.

### BACKGROUND

Correlated multiple sampling (CMS) technology is advantageous in capable of improving the signal-to-noise ratio, and has been applied in a column analog-to-digital converter (column ADC) of image sensing modules, wherein the column analog-to-digital converter is applied to the image sensing module), wherein the column analog-to-digital converter only needs to perform the analog-to-digital conversion on a plurality of analog pixel values from one pixel column in the pixel array. In the prior art, an analog-to-digital converter performs the correlated multiple sampling in a digital domain, and a high sampling rate is required. Since the demand for a sampling rate in a case where a analog-to-digital converter employs the correlated multiple sampling is higher, this technology is not suitable for global analog-to-digital converters (global ADCs) in which the analog-to-digital conversion shall be implemented on all the analog pixel values from the pixel array.

However, compared with a global ADC, the column ADC has the disadvantage of occupying a larger circuit area and consuming greater power consumption. In addition, there may be a mismatch issue among different ADCs corresponding to different pixel rows, wherein the ADC mismatch means that different ADCs convert a same analog value into different digital values.

Therefore, there is a need in the related art for further improvements.

### BRIEF SUMMARY OF THE INVENTION

In view of the foregoing, the purpose of some embodiments of the present invention is to provide an analog read circuit and an image sensing module capable of implementing the correlated multiple sampling in an analog domain.

To address the above-mentioned technical issues, embodiments of the present invention provide an analog read circuit, coupled between a pixel circuit and an analog-to-digital converter, wherein the pixel circuit comprises a transmission gate, a reset transistor, a selection gate and a pixel output end. an amplifier, comprising a first input end and a first output end, wherein the first output end is configured to output a read result of the analog read circuit to the analog-to-digital converter; and a sensing multiple sampling unit, coupled to the pixel output end, the first input end and the first output end, and comprising a plurality of sensing sampling averaging units, wherein the plurality of sensing sampling averaging units comprise a plurality of sensing capacitors; wherein, in a selection interval, the sensing multiple sampling unit respectively implements a plurality of sensing sampling operations on pixel values at the pixel output end at a plurality of sensing sampling times to generate a plurality of sensing sampling results; wherein, in an output interval, the sensing multiple sampling unit implements a sensing averaging operation on the plurality of sampling results, and the amplifier outputs the read result, wherein the read result is related to a sensing average of the plurality of sensing sampling results.

For example, at the first sensing sampling time of the plurality of sensing sampling times in the selection interval, a first sensing sampling averaging unit of the plurality of sensing sampling averaging units implements one sensing sampling operation, and in a first sensing sampling interval corresponding to the first sensing sampling operation, a connection between the first sensing capacitor that is corresponding to the first sensing sampling averaging unit and the pixel output end is conducted, and connections between the sensing capacitor of the remaining sensing sampling averaging units and the pixel output end are not conducted.

For example, the plurality of sensing capacitors have a plurality of first ends and a plurality of second ends, and in the output interval, connections among the plurality of first ends of the plurality of sensing capacitors are conducted, connections among the plurality of second ends of the plurality of sensing capacitors are conducted, so as to implement the sensing averaging operation.

For example, in the output interval, connections between the plurality of sensing capacitors and the first input end are conducted, and connections between the plurality of sensing capacitors and the first output end are conducted, and the amplifier outputs the read result.

For example, a first sensing sampling averaging unit of the plurality of sensing sampling averaging units comprises: a first sampling switch, coupled between the first end of the first sensing capacitor of the first sensing sampling averaging unit and the pixel output end; a first averaging switch, coupled to the first sensing capacitor; and a second averaging switch, coupled between the first sensing capacitor and the first input end.

For example, the first averaging switch is coupled between the first sensing capacitor and another sensing capacitor.

For example, the first sensing sampling averaging unit further comprises a second sampling switch, wherein one end of the second sampling switch is coupled to the first sensing capacitor, and the other end receives a common mode voltage.

For example, the plurality of sensing sampling times take place after the transmission gate is conducted.

For example, the amplifier further comprises a second input end and a second output end, and the analog read circuit further comprises: a reset multiple sampling unit, coupled to the pixel output end, the second input end and the second output end, and comprising a plurality of reset sampling averaging units, wherein the plurality of reset sampling averaging units comprise a plurality of reset capacitors; wherein, in the selection interval, the reset multiple sampling unit respectively implements multiple times of a reset sampling operation on the pixel value at the pixel output end at a plurality of reset sampling times, to generate a plurality of reset sampling results; wherein, in the output interval, the reset multiple sampling unit implements a reset averaging operation on the plurality of sampling results, and the amplifier outputs the read result, wherein the read result is related to the difference between the reset average of the plurality of reset sampling results and the sensing average.

For example, at a first reset sampling time of the plurality of reset sampling times in the selection interval, a first reset sampling averaging unit of the plurality of reset sampling averaging units implements one reset sampling operation, and in a first reset sampling interval corresponding to the first reset sampling operation, a connection between the first reset capacitor that is corresponding to the first reset sampling averaging unit and the pixel output end is conducted, and a connection between the reset capacitor of the remaining reset sampling averaging units and the pixel output end are not conducted.

For example, the plurality of reset capacitors have a plurality of first ends and a plurality of second ends, and in the output interval, connections among the plurality of first ends of the plurality of reset capacitors are conducted, and connections among the plurality of second ends of the plurality of reset capacitors are conducted, so as to implement the reset averaging operation.

For example, in the output interval, connections between the plurality of reset capacitors and the first input end are conducted, connections between the plurality of reset capacitors and the second output end are conducted, and the amplifier outputs the read result.

For example, a first reset sampling averaging unit of the plurality of reset sampling averaging units comprises: a third sampling switch, coupled between a first end of a reset capacitor of the first reset sampling averaging unit and the pixel output end; a third averaging switch, coupled to the first reset capacitor; and a fourth averaging switch, coupled between the first reset capacitor and the first input end.

For example, the third averaging switch is coupled between the first reset capacitor and the first output end.

For example, the third averaging switch is coupled between the first reset capacitor and another reset capacitor.

For example, the first reset sampling averaging unit further comprises a fourth sampling switch, wherein one end of the fourth sampling switch is coupled to the first reset capacitor, and the other end receives a common mode voltage.

For example, the plurality of reset sampling times take place before the transmission gate is conducted and after the reset transistor is conducted.

Embodiments of the present invention provide an image sensing module, comprising a plurality of pixel circuit, arranged in an array, wherein each pixel circuit comprises a transmission gate, a reset transistor, a selection gate and a pixel output end; an analog-to-digital converter; and an analog read circuit, coupled between the plurality of pixel circuits and the analog-to-digital converter, wherein the analog read circuit comprises: an amplifier, comprising a first input end and a first output end, wherein the first output end is configured to output a read result of the analog read circuit to the analog-to-digital converter; and a sensing multiple sampling unit, coupled to the pixel output end, the first input end and the first output end, and comprising a plurality of sensing sampling averaging units, wherein the plurality of sensing sampling averaging units comprise a plurality of sensing capacitors; wherein, in a selection interval, the sensing multiple sampling unit respectively implements a plurality of sensing sampling operations on pixel values at the pixel output end at a plurality of sensing sampling times to generate a plurality of sensing sampling results; wherein, in an output interval, the sensing multiple sampling unit implements a sensing averaging operation on the plurality of sampling results, and the amplifier outputs the read result, wherein the read result is related to a sensing average of the plurality of sensing sampling results.

For example, the analog-to-digital converter is a global analog-to-digital converter.

The present invention employs an analog read circuit to implement the correlated multiple sampling operation and averaging operation on an analog pixel value in an analog domain, so that a signal-to-noise ratio of a system is improved. In addition, due to the fact that an operation time required by the analog read circuit of the present invention is extremely short, the analog read circuit can be applied to the image sensing module of a global analog-to-digital converter, thereby achieving the advantages of reducing the circuit area and power consumption.

### BRIEF DESCRIPTION OF THE DRAWINGS

Figure 1 is a schematic diagram of an image sensing module according to embodiments of the present invention;
Figure 2 is a schematic diagram of an analog read circuit according to embodiments of the present invention;
Figure 3 is a schematic diagram of a plurality of signals according to embodiments of the present invention;
Figure 4 is an equivalent circuit diagram of a sensing multiple sampling unit in a selection interval according to the present invention;
Figure 5 is an equivalent circuit diagram of the sensing multiple sampling unit of Figure 4 in an output interval;
Figure 6 is a schematic diagram of a sensing multiple sampling unit according to embodiments of the present invention;
Figure 7 is a schematic diagram of a plurality of signals applied to the sensing multiple sampling unit of Figure 6;
Figure 8 is a schematic diagram of an analog read circuit according to embodiments of the present invention;
Figure 9 is a schematic diagram of a plurality of signals applied to the sensing multiple sampling unit of Figure 8;
Figure 10 is an equivalent circuit diagram of the sensing multiple sampling unit of Figure 8 in a selection interval;
Figure 11 is an equivalent circuit diagram of the sensing multiple sampling unit of Figure 8 in an output interval.

### DETAILED DESCRIPTION

To further explain the purposes, technical solutions and advantages of the present application, the appended drawings and embodiments are discussed below to give a detailed description of the present invention. It should be noted that the embodiments provided herein are used to explain the present invention, and shall not be used to limit the present application.

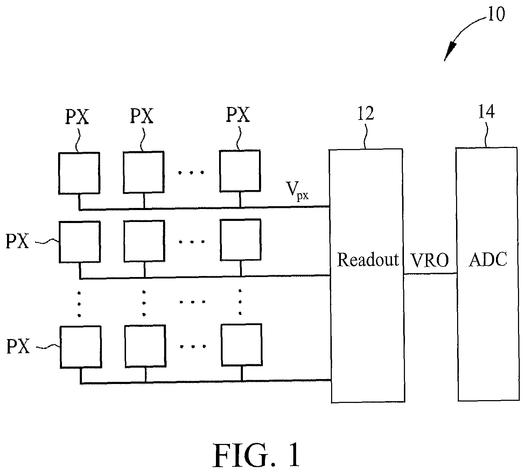

Figure 1 is a schematic diagram of an image sensing module 10 according to embodiments of the present invention. The image sensing module 10 comprises a plurality of pixel circuits PX, an analog read circuit (Readout) 12 and an analog-to-digital converter (ADC) 14. The plurality of pixel circuits PX are arranged in an array and coupled to the analog read circuit 12. The analog read circuit 12 reads an analog pixel value V_{PX} corresponding to each pixel circuit PX at different times to generate an analog read result VRO, and outputs the read result VRO to the ADC 14. Furthermore, the analog read circuit 12 can implement a correlated multiple sampling (CMS) operation on the analog pixel value V_{PX} in an analog domain to improve a signal-to-noise ratio of the read result VRO. That is, the analog read circuit 12 can implement the sampling operation on the analog pixel value V_{PX} at different times to generate a plurality of sampling results, and implements an averaging operation on the plurality of sampling to output the read result VRO, whereas the read result VRO is related to the average of a plurality of sampling result. The noise energy can be decreased by using the averaging operation so that the signal-to-noise ratio can be increased.

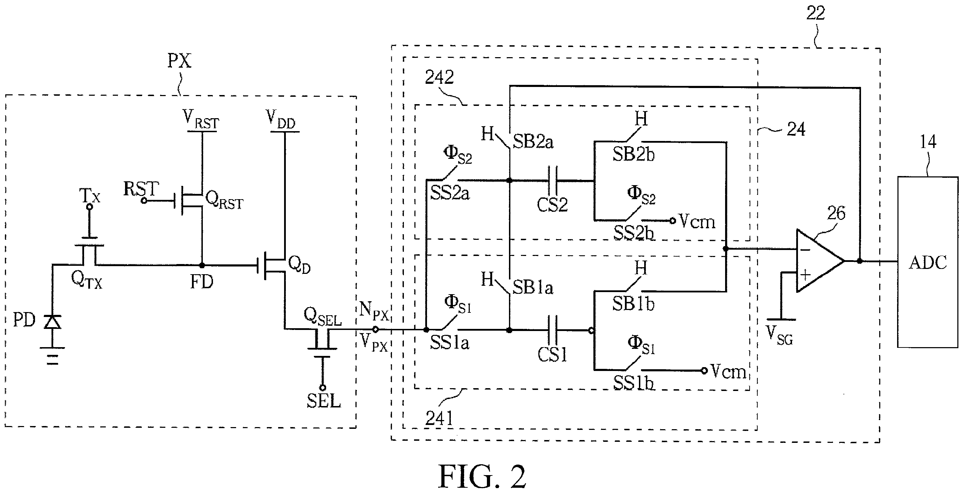

Specifically, please refer to Figure 2; Figure 2 is a schematic diagram of an analog read circuit 22 and a pixel circuit PX according to embodiments of the present invention. The analog read circuit 22 can be configured to embody the analog read circuit 12 of Figure 1. For the ease of description, Figure 2 only illustrates a single pixel circuit PX. The analog read circuit 22 is coupled between the pixel output end N_{PX} of the pixel circuit PX and the ADC 14. The pixel circuit PX outputs a pixel value V_{PX} at the pixel output end N_{PX}. The analog read circuit 22 comprises a sensing multiple sampling unit 24 and an amplifier 26. The sensing multiple sampling unit 24 is coupled to the pixel output end N_{PX}, a negative input end (labeled with a "-" sign) of the amplifier 26 and an output end of the amplifier 26. Moreover, the positive input end (labeled with a "+" sign) of the amplifier 26 receives a constant voltage V_{SG}, wherein the constant voltage V_{SG} may be a ground voltage or a signal ground voltage.

In a sampling phase, the sensing multiple sampling unit 24 may implement a sampling operation on the pixel value V_{PX} at two different sensing sampling times (t_{S1}, t_{S2}), respectively, to generate two sensing sampling results. In an amplifying phase, the sensing multiple sampling unit 24 may implement an averaging operation on the two sampling results obtained in the sampling phase and output a read result VRO, wherein the read result VRO is related to the average of the two sampling results.

More specifically, the sensing multiple sampling unit 24 comprises sensing sampling averaging units 241 and 242. The sensing sampling averaging unit 241 comprises a sensing capacitor CS1, sampling switches SS1a and SS1b and averaging switches SB1a and SB1b. The sensing sampling averaging unit 242 comprises a sensing capacitor CS2, sampling switches SS2a and SS2b and averaging switches SB2a and SB2b. The sampling switches SS1a and SS1b are under the control of a signal Φ_{S1}. The sampling switches SS2a and SS2b are under the control of a signal Φ_{S2}. The averaging switches SB1a, SB1b, SB2a and SB2b are under the control of a signal H. One end of the sampling switches SS1b and SS2b are respectively coupled to sensing capacitors CS1 and CS2, and the other end receives a common mode voltage Vcm. The averaging switch SB1a is coupled between the sensing capacitor CS1 and the sensing capacitor CS2. The averaging switch SB2a is coupled between the sensing capacitor CS2 and the output end of the amplifier 26. The averaging switches SB1b and SB2b are respectively coupled between sensing capacitors CS1 and CS2 and the negative input end of the amplifier 26.

Moreover, a circuit structure of the pixel circuit PX is briefly described below. As shown in Figure 2, the pixel circuit PX may comprise a photo diode PD, a transmission gate Q_{TX}, a reset transistor Q_{RST}, a buffer transistor Q_{D}, a selection gate Q_{SEL}, and a pixel output end N_{PX}. The transmission gate Q_{TX}, reset transistor Q_{RST} and selection gate Q_{SEL} are respectively under the control of a transmission signal TX, a reset signal RST, and a selection signal SEL. The pixel circuit PX outputs the pixel value V_{PX} at the pixel output end N_{PX}.

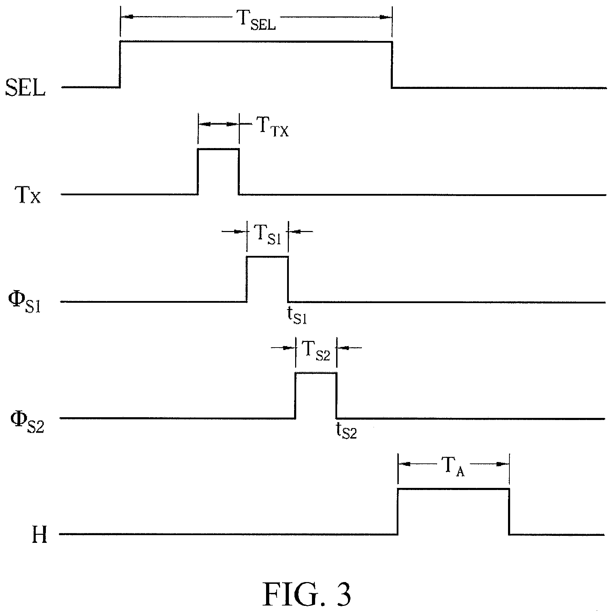

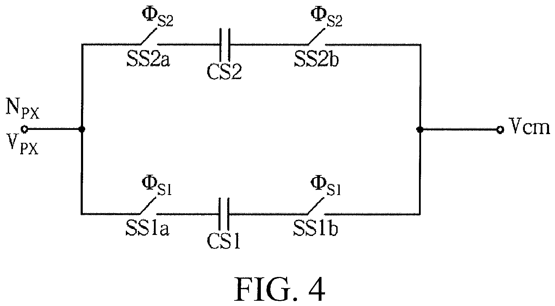

The description regarding operations of the pixel circuit PX and the analog read circuit 22 is provided below. Please refer to Figure 3, which is a timing diagram of the selection signal SEL, transmission signal TX, and signals Φ_{S1}, Φ_{S2} and H. When the analog read circuit 22 intends to read the pixel circuit PX, the selection gate Q_{SEL} corresponding to the pixel circuit PX is conducted (that is, the selection signal SEL is a high voltage level, wherein a period where the selection signal SEL is a high voltage level is referred to as a selection interval T_{SEL}). In the selection interval T_{SEL} (the sampling phase is within the selection interval T_{SEL}), the transmission gate Q_{TX} is conducted, and at this moment, the photo-electrons stored in the photo diode PD are drawn to the node FD of the pixel circuit PX. After the interval T_{TX}, the sampling switches SS1a and SS1b and the sampling switches SS2a and SS2b are respectively conducted in the sensing sampling interval T_{S1} and the sensing sampling interval T_{S2}. When the sampling switches SS1a and SS1b are conducted in the sensing sampling interval T_{S1}, a first end of the sensing capacitor CS1 is connected to the pixel output end N_{PX} (i.e., the connection between the sensing capacitor CS1 and the pixel output end N_{PX} is conducted), and a second end of the sensing capacitor CS1 receives the common mode voltage Vcm. The connection between a first end of the sensing capacitor CS2 and the pixel output end N_{PX} is not conducted. Similarly, when the sampling switches SS2a and SS2b are conducted, the first end of the sensing capacitor CS2 is connected to the pixel output end N_{PX} (i.e., the connection between the sensing capacitor CS2 and pixel output end N_{PX} is conducted), and the second end of the sensing capacitor CS2 receives the common mode voltage Vcm. The connection between the first end of the sensing capacitor CS1 and the pixel output end N_{PX} is not conducted. More specifically, the sensing sampling averaging units 241 and 242 may implement the sensing sampling operation on the pixel value V_{PX}, respectively, at time t_{S1}, t_{S2}, which respectively corresponds to the falling edge of signal Φ_{S1} and the falling edge of the signal Φ_{S2}. The amount of variation in charges of the sensing capacitors CS1 and CS2 may be considered as the sensing sampling result of the sensing sampling operation. Moreover, in the selection interval T_{SEL}, the averaging switches SB1a, SB1b, SB2a and SB2b are all not conducted. In other words, in the selection interval T_{SEL}, the sensing multiple sampling unit 24 (the part related to the change in the charges) is equivalent to the equivalent circuit illustrated in Figure 4.

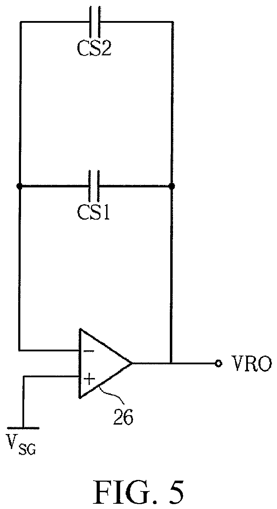

On the other hand, after the sensing multiple sampling unit 24 completes the sampling operation (or the selection gate Q_{SEL} becomes not conducted from the conduction state), the averaging switches SB1a, SB1b, SB2a and SB2b are all connected and the sampling switches SS1a, SS1b, SS2a and SS2b are all not conducted in the output interval T_{A} (the output interval T_{A} may refer to the above-mentioned amplifying phase). At this moment, the sensing multiple sampling unit 24 (the part related to the change in the charges) is equivalent to the equivalent circuit of Figure 5. As shown in Figure 5, the first ends of the sensing capacitors CS1 and CS2 are connected to each other (because the connection of the first ends of the sensing capacitors CS1 and CS2 is conducted), the second ends of the sensing capacitors CS1 and CS2 are connected to each other (because the connection of the second ends of the sensing capacitors CS1 and CS2 is conducted). Hence, the charges stored in the sensing capacitor CS1 and the sensing capacitor CS2 are able to be shared therebetween (i.e., charge sharing), thereby achieving the effect of implementing the averaging operation on the two sensing sampling results. Moreover, the first ends of the sensing capacitors CS1 and CS2 are coupled to the output end of the amplifier 26, and the second ends of the sensing capacitors CS1 and CS2 are coupled to the negative input end of the amplifier 26. In this way, the amplifier 26 can output the read result VRO, wherein the read result VRO is related to the sensing average of the two sensing sampling results.

Briefly, the two sensing sampling averaging units (241 and 242) of the sensing multiple sampling unit 24 may implement two sensing sampling operations on the pixel value V_{PX} at the two different sensing sampling times t_{S1} and t_{S2} of the selection interval T_{SEL}, respectively, so as to generate two sensing sampling results, and implement an averaging operation on the two sensing sampling results in the output interval T_{A}, so that the sensing multiple sampling unit 24 may output the read result VRO related to the sensing average.

It should be noted that, the sensing multiple sampling unit according to the present invention is not limited to those comprising two sensing sampling averaging units. Rather, the sensing multiple sampling unit may comprise M sensing sampling averaging units (wherein M is greater than 2), which may implement M sensing sampling operations on the pixel value V_{PX} at M different sensing sampling times t_{S1}∼ t_{SM} of the selection interval T_{SEL}, respectively, so as to generate M sensing sampling results, and implement an averaging operation on the M sensing sampling results in the output interval T_{A}, so that the sensing multiple sampling unit 24 may output the read result VRO related to the sensing average.

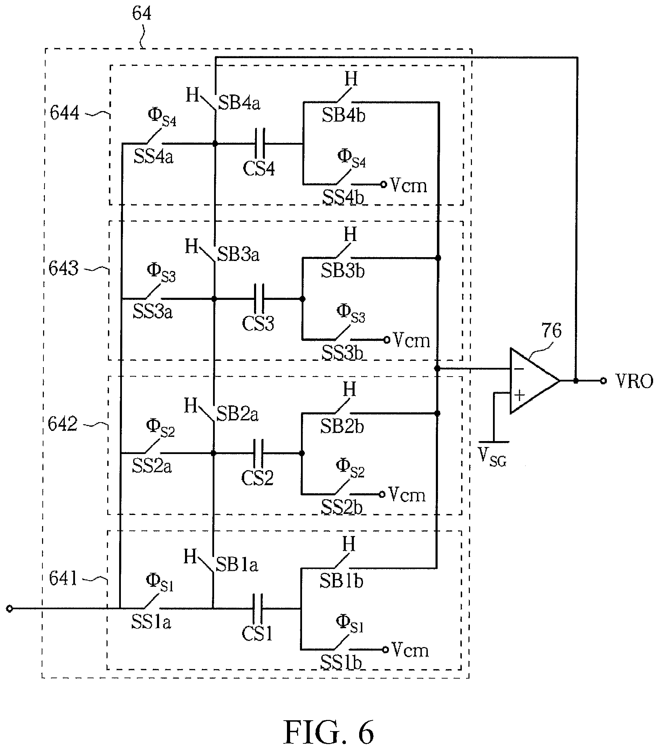

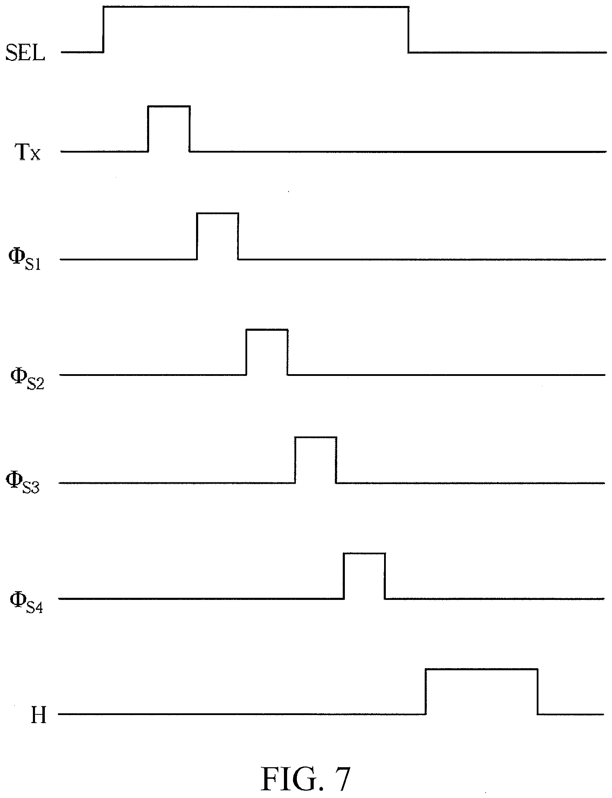

For example, please refer to Figure 6 and Figure 7; Figure 6 is a schematic diagram of a sensing multiple sampling unit 64 according to embodiments of the present invention. Figure 7 is a timing diagram of signals Φ_{S1}∼Φ_{S4} and H applied to the sensing multiple sampling unit 64. The sensing multiple sampling unit 64 comprises sensing sampling averaging units 641, 642, 643 and 644 (e.g., an embodiment of M=4). The principle of the operation of the sensing multiple sampling unit 64 is similar to that of the sensing multiple sampling unit 24, and hence, a detailed description thereof is omitted here.

On the other hand, in order to enable the read result VRO to better reflect the light-sensing level of the photodiode PD in the pixel circuit PX, before the transmission gate Q_{TX} is conducted, the image sensing module may first conduct the reset transistor Q_{RST} of the pixel circuit PXs, and after the Q_{RST} is conducted and before the transmission gate Q_{TX} is conducted, the analog read circuit is used to read the pixel value V_{PX} at the pixel output end N_{PX} (the pixel value V_{PX} at this moment is referred to as a reset pixel value V_{PX,R}). After the transmission gate Q_{TX} is conducted, the analog read circuit may again read the pixel value V_{PX} of the pixel output end N_{PX} (the pixel value at this moment is referred to as a signal pixel value V_{PX,S}). The analog read circuit may output the read result VRO. In this way, the read result is related to the subtraction result of the signal pixel value V_{PX,S} and the reset pixel value V_{PX,R}. After the transistor Q_{RST} is conducted and before the transmission gate Q_{TX} is conducted, the analog read circuit 12 may also use the correlated multiple sampling (CMS) to read the reset pixel value V_{PX,R}. That is, the analog read circuit of the present invention may implement multiple times of reset sampling operations on the reset pixel value V_{PX,R} to generate a plurality of reset sampling results, and implement the reset averaging operation on the plurality of reset sampling results to obtain a reset average of the plurality of reset sampling results. The read result VRO outputted by the analog read circuit may be related to the subtraction result of the sensing average and the reset average.

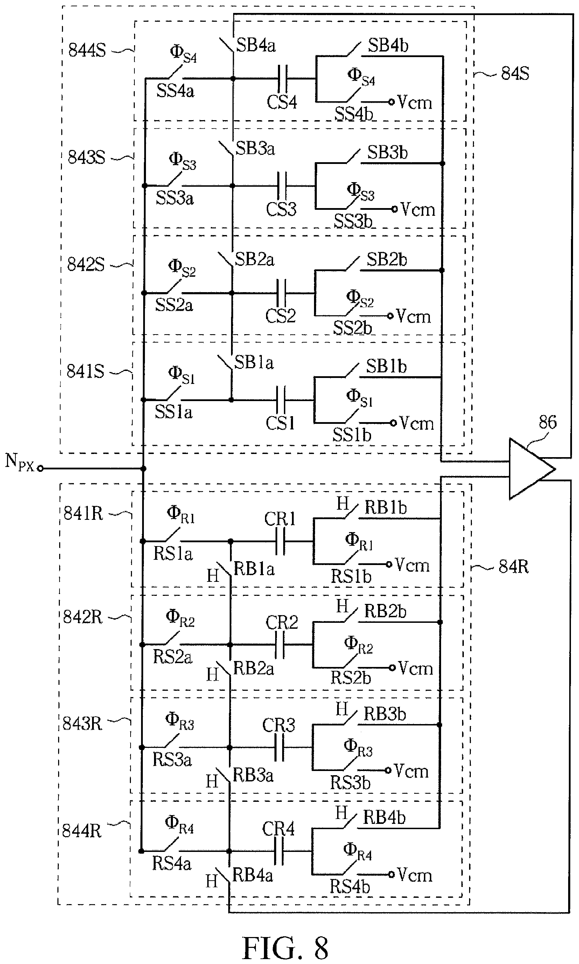

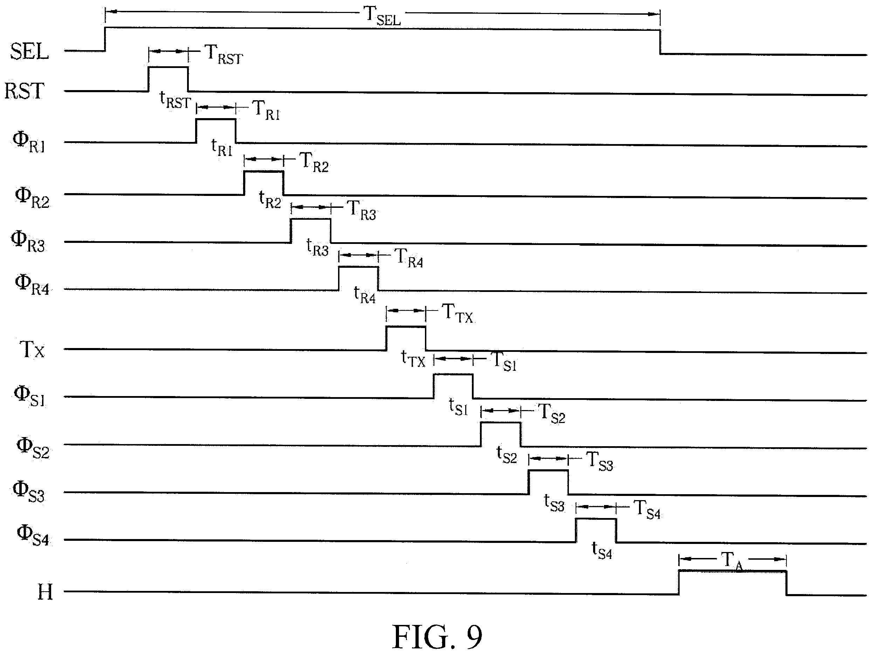

Specifically, please refer to Figure 8 and Figure 9; Figure 8 is a schematic diagram of an analog read circuit 82 according to embodiments of the present invention. Figure 9 is a timing diagram of signals Φ_{R1} ∼ Φ_{R4}, Φ_{S1} ∼ Φ_{S4}, and H applied to a sensing multiple sampling unit 84. An analog read circuit 82 comprises a sensing multiple sampling unit 84S, a reset multiple sampling unit 84R, and an amplifier 86. The amplifier 86 is a fully differential operational amplifier. The sensing multiple sampling unit 84S is coupled to a pixel output end N_{PX} and a first input end and a first output end of the amplifier 86. The reset multiple sampling unit 84R is coupled to the pixel output end N_{PX} and a second input end and a second output end of the amplifier 86.

The reset multiple sampling unit 84R comprises four reset sampling averaging units 841R ∼ 844R. The reset sampling averaging unit 841R comprises a reset capacitor CR1, sampling switches RS1a and RS1b, and averaging switches RB1a and RB1b. The sampling switches RS1a and RS1b are under the control of the signal Φ_{R1}. The averaging switches RB1a and RB1b are under the control of the signal H. The circuit structure of the reset sampling averaging units 842R∼844R is similar to that of the reset sampling averaging unit 841R. The sampling switches RS2a and RS2b are under the control of the signal Φ_{R2}. The sampling switches RS3a and RS3b are under the control of the signal Φ_{R3}. The sampling switches RS4a and RS4b are under the control of the signal Φ_{R4}. The averaging switches RB2a, RB2b, RB3a, RB3b, RB4a and RB4b are under the control of the signal H. It should be noted that, the averaging switch RB1a is coupled between the reset capacitor CR1 and the reset capacitor CR2. The averaging switch RB2a is coupled between the reset capacitor CR2 and the reset capacitor CR3. The averaging switch RB3a is coupled between the reset capacitor CR3 and the reset capacitor CR4. The averaging switch RB4a is coupled between the reset capacitor CR4 and the second output end of the amplifier 86. The structure of the internal circuit of the sensing multiple sampling unit 84S is the same as that of the sensing multiple sampling unit 64/ the reset multiple sampling unit 84R, and hence, a detailed description thereof is omitted here.

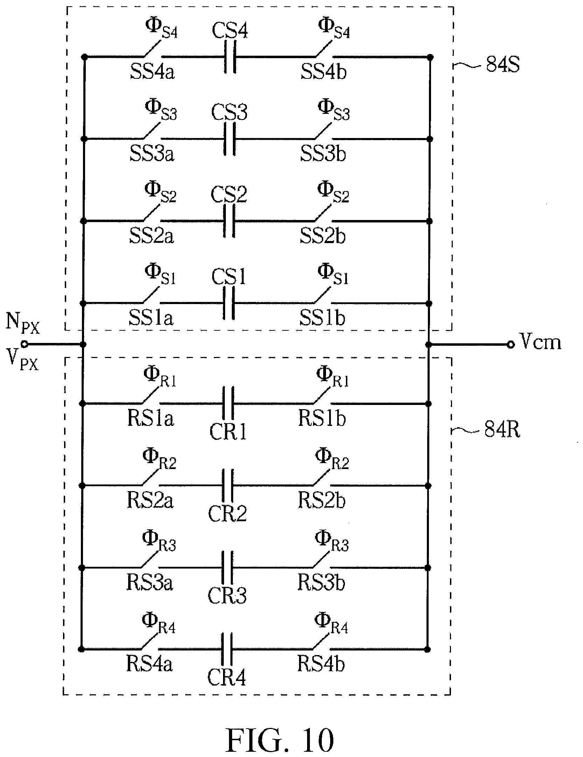

In the selection interval T_{SEL}, the reset transistor Q_{RST} is first conducted in a reset interval T_{RST}. After the reset transistor Q_{RST} is conducted, the reset multiple sampling unit 84R implements the reset sampling operation on the pixel value V_{PX} of the pixel output end N_{PX} at reset sampling times t_{R1}∼t_{R4} (corresponding to the reset sampling intervals T_{R1} ∼ T_{R4}, respectively,) to generate four reset sampling results as the amount of variation in the charge of the reset capacitors CR1 ∼ CR4. Next, the transmission gate Q_{TX} is conducted in the transmission interval T_{TX}. After the transmission gate Q_{TX} is conducted, the sensing multiple sampling unit 84S implements the sensing sampling operation on the pixel value V_{PX} of the pixel output end N_{PX} at the sensing sampling times t_{S1}∼t_{S4} (corresponding to the sensing sampling intervals T_{S1} ∼ T_{S4}, respectively,) to generate four sensing sampling results as the amount of variation in the charge of the sensing capacitors CS1∼CS4. Moreover, the averaging switches SB1a∼SB4a and SB1b∼SB4b are not conducted in the selection interval T_{SEL}. The sensing multiple sampling unit 84S and the reset multiple sampling unit 84R (the part related to the change in the charge) are equivalent to the equivalent circuit of Figure 10.

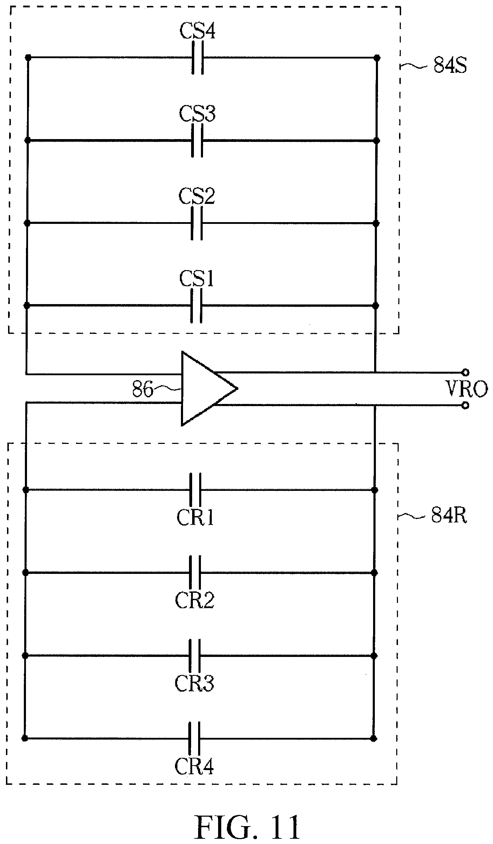

In the output interval T_{A}, the averaging switches SB1a∼SB4a, SB1b∼SB4b are all conducted, the sampling switches SS1a∼SS4a, SS1b∼SS4b are all not conducted. The sensing multiple sampling unit 84S and the reset multiple sampling unit 84R (the part related to the change in the charge) are equivalent to the equivalent circuit of Figure 11. As shown in Figure 11, since the first ends of the sensing capacitors CS1∼CS4 are all connected with one another, and the second ends of the sensing capacitors CS1∼CS4 are all connected with one another, the charge stored in the sensing capacitors CS1∼CS4 may be shared among these sensing capacitors, thereby achieving the effect of implementing a sensing averaging operation on the four sensing sampling results to generate the sensing average of the four sensing sampling results. On the other hand, since the first ends of the reset capacitors CR1 ∼ CR4 are connected with one another, and the second ends of the reset capacitors CR1 ∼ CR4 are connected with one another, the charge stored in the reset capacitors CR1∼CR4 are shared among the reset capacitors CR1 ∼ CR4, thereby achieving the effect of implementing the reset averaging operation on the four reset sampling results to generate the reset average of the four reset sampling results. Moreover, since the first ends and second ends of the sensing capacitors CS1∼CS4 are connected to the first input end and first output end of the fully differential amplifier 86, and the first ends and second ends of the reset capacitors CR1 ∼ CR4 are connected to the second input end and second output end of the fully differential amplifier 86, the read result VRO outputted by the fully differential amplifier 86 is related to the subtraction result of the sensing average and the reset average.

It should be noted that, the analog read circuits 12 and 82 of the present invention can implement the correlated multiple sampling on the analog pixel value V_{PX} in the analog domain and implement the average operation in the analog domain. The required operation time is extremely short, and therefore the analog read circuits 12 and 82 can be applied to an image sensing module 10 adopting a global analog-to-digital converter (global analog-to-digital converter). In other words, the ADC 14 may be a global analog-to-digital converter. That is, the image sensing module 10 may include only a single ADC 14, and the ADC 14 needs to implement the analog-to-digital conversion on the pixel values for all the pixel circuits PX of the image sensing module 10. In other words, the image sensing module of the present invention does not need to include a plurality of analog-to-digital converters (e.g., a column analog-to-digital converter corresponding to a column in a pixel array), which may achieve the advantage of a high signal-to-noise ratio of multiple sampling operations under the condition that the circuit area and the power consumption are reduced.

In view of the foregoing, the present invention uses an analog read circuit to implement a correlated multiple sampling operation and an averaging operation on analog pixel values, so that a signal-to-noise ratio of a system is improved. In addition, due to the fact that an operation time required by the analog read circuit is extremely short, the analog read circuit can be applied to the image sensing module adopting the global analog-to-digital converter, so that the advantages of reducing the circuit area and power consumption can be achieved.

The foregoing outlines a portion of embodiments of the present disclosure, and shall not be used to limit the present application; any modification, equivalent substitution or improvement made within the spirits and principles of the present application shall be included in the scope of protection of the present application.

## Claims

1. An analog read circuit, coupled between a pixel circuit and an analog-to-digital converter, the pixel circuit comprising a transmission gate, a reset transistor, a selection gate and a pixel output end, wherein the analog read circuit comprises:
an amplifier, comprising a first input end and a first output end, wherein the first output end is configured to output a read result of the analog read circuit to the analog-to-digital converter; and
a sensing multiple sampling unit, coupled to the pixel output end, the first input end and the first output end, and comprising a plurality of sensing sampling averaging units, wherein the plurality of sensing sampling averaging units comprise a plurality of sensing capacitors;
wherein, in a selection interval, the sensing multiple sampling unit respectively implements a plurality of sensing sampling operations on pixel values at the pixel output end at a plurality of sensing sampling times to generate a plurality of sensing sampling results;
wherein, in an output interval, the sensing multiple sampling unit implements a sensing averaging operation on the plurality of sampling results, and the amplifier outputs the read result, wherein the read result is related to a sensing average of the plurality of sensing sampling results.

2. The analog read circuit of claim 1, wherein at the first sensing sampling time of the plurality of sensing sampling times in the selection interval, a first sensing sampling averaging unit of the plurality of sensing sampling averaging units implements one sensing sampling operation, and in a first sensing sampling interval corresponding to the first sensing sampling operation, a connection between the first sensing capacitor that is corresponding to the first sensing sampling averaging unit and the pixel output end is conducted, and connections between the sensing capacitor of the remaining sensing sampling averaging units and the pixel output end are not conducted.

3. The analog read circuit of claim 1, wherein the plurality of sensing capacitors have a plurality of first ends and a plurality of second ends, and in the output interval, connections among the plurality of first ends of the plurality of sensing capacitors are conducted, connections among the plurality of second ends of the plurality of sensing capacitors are conducted, so as to implement the sensing averaging operation.

4. The analog read circuit of claim 1, wherein in the output interval, connections between the plurality of sensing capacitors and the first input end are conducted, and connections between the plurality of sensing capacitors and the first output end are conducted, and the amplifier outputs the read result.

5. The analog read circuit of claim 1, wherein a first sensing sampling averaging unit of the plurality of sensing sampling averaging units comprises:
a first sampling switch, coupled between the first end of the first sensing capacitor of the first sensing sampling averaging unit and the pixel output end;
a first averaging switch, coupled to the first sensing capacitor; and
a second averaging switch, coupled between the first sensing capacitor and the first input end.

6. The analog read circuit of claim 5, wherein the first averaging switch is coupled between the first sensing capacitor and the first output end.

7. The analog read circuit of claim 5, wherein the first averaging switch is coupled between the first sensing capacitor and another sensing capacitor.

8. The analog read circuit of claim 5, wherein the first sensing sampling averaging unit further comprises a second sampling switch, wherein one end of the second sampling switch is coupled to the first sensing capacitor, and the other end receives a common mode voltage.

9. The analog read circuit of claim 1, wherein the plurality of sensing sampling times take place after the transmission gate is conducted.

10. The analog read circuit of claim 1, wherein the amplifier further comprises a second input end and a second output end, and the analog read circuit further comprises:
a reset multiple sampling unit, coupled to the pixel output end, the second input end and the second output end, and comprising a plurality of reset sampling averaging units, wherein the plurality of reset sampling averaging units comprise a plurality of reset capacitors;
wherein, in the selection interval, the reset multiple sampling unit respectively implements multiple times of a reset sampling operation on the pixel value at the pixel output end at a plurality of reset sampling times, to generate a plurality of reset sampling results;
wherein, in the output interval, the reset multiple sampling unit implements a reset averaging operation on the plurality of sampling results, and the amplifier outputs the read result, wherein the read result is related to the difference between the reset average of the plurality of reset sampling results and the sensing average.

11. The analog read circuit of claim 10, wherein at a first reset sampling time of the plurality of reset sampling times in the selection interval, a first reset sampling averaging unit of the plurality of reset sampling averaging units implements one reset sampling operation, and in a first reset sampling interval corresponding to the first reset sampling operation, a connection between the first reset capacitor that is corresponding to the first reset sampling averaging unit and the pixel output end is conducted, and a connection between the reset capacitor of the remaining reset sampling averaging units and the pixel output end are not conducted.

12. The analog read circuit of claim 10, wherein the plurality of reset capacitors have a plurality of first ends and a plurality of second ends, and in the output interval, connections among the plurality of first ends of the plurality of reset capacitors are conducted, and connections among the plurality of second ends of the plurality of reset capacitors are conducted, so as to implement the reset averaging operation.

13. The analog read circuit of claim 10, wherein in the output interval, connections between the plurality of reset capacitors and the first input end are conducted, connections between the plurality of reset capacitors and the second output end are conducted, and the amplifier outputs the read result.

14. The analog read circuit of claim 10, wherein a first reset sampling averaging unit of the plurality of reset sampling averaging units comprises:
a third sampling switch, coupled between a first end of the first reset capacitor of the first reset sampling averaging unit and the pixel output end;
a third averaging switch, coupled to the first reset capacitor; and
a fourth averaging switch, coupled between the first reset capacitor and the first input end.

15. The analog read circuit of claim 14, wherein the third averaging switch is coupled between the first reset capacitor and the first output end.

16. The analog read circuit of claim 14, wherein the third averaging switch is coupled between the first reset capacitor and another reset capacitor.

17. The analog read circuit of claim 14, wherein the first reset sampling averaging unit further comprises a fourth sampling switch, wherein one end of the fourth sampling switch is coupled to the first reset capacitor, and the other end receives a common mode voltage.

18. The analog read circuit of claim 10, wherein the plurality of reset sampling times take place before the transmission gate is conducted and after the reset transistor is conducted.

19. An image sensing module, comprising:
a plurality of pixel circuits, arranged in an array, wherein each pixel circuit comprises a transmission gate, a reset transistor, a selection gate and a pixel output end;
an analog-to-digital converter; and
an analog read circuit, coupled between the plurality of pixel circuits and the analog-to-digital converter, wherein the analog read circuit is the analog read circuit according to any of claims 1-18.

20. The image sensing module of claim 19, wherein the analog-to-digital converter is a global analog-to-digital converter.
